# EUROPÄISCHE PATENTSCHRIFT

(11) **EP 1 717 854 B1**
(45) Veröffentlichungstag und Bekanntmachung des Hinweises auf die Patenterteilung: **29.07.2020**
(21) Anmeldenummer: 06004421.1
(22) Anmeldetag: 03.03.2006
(51) Int. Cl.: H01L 23/373, H01L 33/00, H01L 23/00, H01L 33/62

(54) **Halbleiterchip mit einer Lötschichtenfolge und Verfahren zum Löten eines Halbleiterchips**
Semiconductor device with a plurality of soldering layers and process therefor
Dispositif semiconducteur ayant une pluralité de couches de soudure et procédé correspondant.

(30) Priorität: 23.06.2005 DE 102005029246; 31.03.2005 DE 102005015147
(43) Veröffentlichungstag der Anmeldung: 02.11.2006
(73) Patentinhaber: OSRAM Opto Semiconductors GmbH, 93055 Regensburg (DE)
(72) Erfinder: Plössl, Andreas, 93051 Regensburg (DE); Illek, Stefan, 93093 Donaustauf (DE); Grolier, Vincent, 93047 Regensburg (DE)
(74) Vertreter: Epping - Hermann - Fischer

(56) Entgegenhaltungen:
- WO-A2-03/098706
- JP-A- 2004 235 649
- US-A- 5 234 153
- US-A1- 2004 256 632
- US-A1- 2004 259 278
- US-A1- 2005 090 031

## Beschreibung

Die Erfindung betrifft einen Halbleiterchip mit einer Lötschichtenfolge gemäß dem Oberbegriff des Patentanspruchs 1 und ein Verfahren zum Löten eines Halbleiterchips.

Niederschmelzende Metalle, die als Lot oder Lotbestandteile verwendet werden, haben in der Regel eine starke Neigung zur Oxidation. Bei der Herstellung von Fügeverbindungen mittels eines Lots, das ein niederschmelzendes Metall enthält, behindert daher oftmals eine Oxidbildung an der Oberfläche der Lotschicht die vollständige Benetzung eines der Fügepartner. Offene, sogenannte kalte Lötstellen oder nur an wenigen Punkten verbundene Lötverbindungen können die Folge sein. Durch Löten unter Schutzgas oder einer reduzierenden Atmosphäre kann die Oxidbildung vermindert werden. Dies ist allerdings mit einem erhöhten Herstellungsaufwand verbunden. Weiterhin kann eine Verminderung der Oxidation auch durch die Verwendung von Flussmittel erreicht werden. Insbesondere bei dünnen Lötverbindungen oder großflächigen Fügestellen ist dies aber oft nicht praktikabel oder erwünscht.

In der Druckschrift DE 103 50 707 wird ein elektrischer Kontakt für einen optoelektronischen Halbleiterchip beschrieben, bei dem eine Metallschicht auf der Halbleiteroberfläche einen elektrischen Metall-Halbleiterkontakt herstellt. Um eine Diffusion von Bestandteilen der Lotschicht in die auf die Halbleiteroberfläche aufgebrachte Metallschicht, die vorzugsweise als Spiegel für die von dem Halbleiterchip emittierte Strahlung wirkt, zu vermeiden, ist zwischen der Lotschicht und der Metallschicht eine Barriereschicht enthalten, beispielsweise eine Barriereschicht aus TiWN.

Häufig besteht weiterhin das Problem, dass Lotschichten auf einer derartigen Barriereschicht schlecht haften. Weiterhin haften Lotschichten oftmals auch nur schlecht auf metallischen Trägern. Die Ursache dafür ist die schlechte Benetzbarkeit der Barriereschichten und/oder der Oberfläche des Trägers. Zwischen der Barriereschicht und der Lotschicht beziehungsweise zwischen der Trägeroberfläche und dem Lot wird aus diesem Grund eine gut benetzende Schicht, beispielsweise eine Benetzungsschicht aus Platin, eingefügt. Dabei besteht aber die Gefahr, dass das Material der Benetzungsschicht, insbesondere Platin, zumindest geringfügig mit dem Lot reagiert. Bei dünnen Lotschichten kann dadurch die Stöchiometrie des Lots nachteilig verändert werden.

Weiterhin ist aus der Druckschrift DE 103 50 707 bekannt, die Lotschicht durch Aufbringen einer dünnen Goldschicht vor Oxidation zu schützen.

Bei einigen Lotmetallen besteht aber die Gefahr, dass Lotbestandteile, insbesondere niederschmelzende Metalle, bereits bei geringen Temperaturen, zum Beispiel sogar schon bei Zimmertemperatur, durch eine derartige Oxidationsschutzschicht diffundieren, wodurch die Schutzwirkung vermindert wird. Würde die Dicke der Schutzschicht wesentlich erhöht, um eine Diffusion eines Lotbestandteils zur Oberfläche der Oxidationsschutzschicht zu verhindern, müsste auch die Dicke der Lotschicht entsprechend erhöht werden, wenn die Zusammensetzung des Lots nach dem Aufschmelzvorgang nicht wesentlich durch die Schutzschicht verändert werden soll. Allerdings sind insbesondere beim Löten von Halbleiterchips, beispielsweise bei Löten von LED-Chips in ein LED-Gehäuse in der Regel geringe Lotdicken gefordert, um die Gesamthöhe des Bauteils so gering wie möglich zu halten und das Risiko von Kurzschlüssen an der Chipkante auszuschließen.

US2004/0259278 beschreibt ein Verfahren zum Herstellen lichtaussenderer Halbleiterbauelemente.

US5234153 beschreibt ein Verfahren zur Herstellung einer metallischer Verbindung.

JP2004235649 beschreibt ein Verfahren zum Herstellen eines lichtemittierenden Halbleiter-Bauelements.

Der Erfindung liegt die Aufgabe zugrunde, einen Halbleiterchip mit einer darauf aufgebrachten, verbesserten zur Herstellung einer Lötverbindung vorgesehenen Schichtenfolge anzugeben, die sich insbesondere durch einen verbesserten Schutz der Lotschicht vor Oxidation auszeichnet. Ferner soll ein vorteilhaftes Verfahren zur Herstellung einer Lötverbindung zwischen einem Halbleiterchip und einem Träger angegeben werden.

Diese Aufgabe wird durch einen Halbleiterchip mit einer aufgebrachten Schichtenfolge nach Patentanspruch 1 beziehungsweise durch ein Verfahren nach Patentanspruch 14 gelöst. Vorteilhafte Ausgestaltungen und Weiterbildungen der Erfindung sind Gegenstand der abhängigen Ansprüche. Erfindungsgemäß ist auf den Halbleiterchip eine zur Herstellung einer Lötverbindung vorgesehenen Schichtenfolge aufgebracht. Die Schichtenfolge umfasst eine Lotschicht und eine vom Halbleiterchip aus gesehen der Lotschicht nachfolgende Oxidationsschutzschicht. Zwischen der Lotschicht und der Oxidationsschutzschicht ist eine Barriereschicht enthalten, wobei die Barriereschicht eine Diffusion eines Materials, das Bestandteil der Lotschicht ist, durch die Oxidationsschutzschicht vermindert. Weiterhin weist die Barriereschicht eine Dicke auf, die höchstens 50 nm beträgt.

Durch die zwischen der Lotschicht und der Oxidationsschutzschicht enthaltene Barriereschicht wird vorteilhaft eine Diffusion von Bestandteilen der Lotschicht zu der von der Lotschicht abgewandten Oberfläche der Oxidationsschutzschicht vermindert. Auf diese Weise wird insbesondere der Gefahr vorgebeugt, dass Bestandteile der Lotschicht vor dem Lötvorgang durch Diffusion durch die Oxidationsschutzschicht hindurch bis an die von der Lotschicht abgewandte Oberfläche der Oxidationsschutzschicht gelangen dort oxidieren, wodurch die Qualität einer Lötverbindung ansonsten nachteilig beeinflusst werden könnte.

Die Barriereschicht enthält bevorzugt mindestens eines der Metalle Ti, V, Cr, Nb, Zr, Hf, Ta, Mo oder W. Diese Materialen sind als Diffusionsbarriere für niedrigschmelzende Metalle besonders geeignet.

Die Barriereschicht ist vorteilhaft derart dick, dass kein oxidationsanfälliger Bestandteil der Lotschicht vor dem Lötprozess an die Oberfläche der Oxidationsschutzschicht gelangen kann. Aus diesem Grund weist die Barriereschicht bevorzugt eine Dicke von 5 nm oder mehr, besonders bevorzugt 10 nm oder mehr, auf.

Andererseits sollte die Dicke der Barriereschicht aber auch nicht zu groß sein, damit das Aufschmelzen und Verschmelzen der Lotbestandteile beim Lötvorgang nicht behindert wird. Die Dicke der Barriereschicht sollte auch deshalb möglichst gering sein, weil die Stöchiometrie des Lots durch die Barriereschicht, die beim Lötvorgang mit aufschmilzt, nicht wesentlich verändert werden soll. Die Dicke der Barriereschicht beträgt deshalb vorteilhaft 100 nm oder weniger, besonders bevorzugt 50 nm oder weniger. Ein besonders bevorzugter Bereich der Dicke der Barriereschicht beträgt zwischen einschließlich 10 nm und einschließlich 50 nm.

Die Lotschicht enthält zum Beispiel ein Metall oder eine Metalllegierung, vorzugsweise Sn, In, Ga, Bi, Pb, Sb, Zn, Cd, Hg, Tl, AuSn, AuIn, AuBi, AgSn oder PbSn. Die Lotschicht kann sowohl eine Einzelschicht aus als auch ein Schichtstapel aus einer Mehrzahl von Schichten sein. Beispielsweise kann die Lotschicht eine Vielzahl von alternierenden Au-Schichten und Sn-Schichten umfassen, die beim Lötvorgang zu einer AuSn-Legierung aufschmelzen.

Die Dicke der Lotschicht beträgt vorteilhaft 3 µm oder weniger, besonders bevorzugt 2 µm oder weniger. Eine derart geringe Dicke der Lotschicht ist vorteilhaft, um die Gesamthöhe eines Bauelements, das einen erfindungsgemäßen Halbleiterchip enthält, so gering wie möglich zu halten. Weiterhin ist bei einer vergleichsweise dünnen Lotschicht die Gefahr vermindert, dass ein Teil des Lots an die Chipkante gelangt und dort einen Kurzschluss verursacht. Eine vergleichsweise dünne Lotschicht ist ferner deshalb vorteilhaft, weil die Gefahr einer Verkippung der Chips bei der Lötmontage und die Schwierigkeit, benachbarte Chips auf gleicher Höhe zu positionieren, vermindert werden. Außerdem sind die Herstellungskosten bei einer vergleichsweise dünnen Lotschicht verhältnismäßig gering.

Die Oxidationsschutzschicht besteht vorteilhaft aus einem gegen Oxidation vergleichsweise unempfindlichen Material. Vorzugsweise ist die Oxidationsschutzschicht aus einem gegen Oxidation vergleichsweise unempfindlichen Metall gebildet, beispielsweise aus Au, Pt, Pd, Ir, Ag oder Rh.

Bei einer weiteren bevorzugten Ausführungsform der Erfindung ist die Oxidationsschutzschicht aus einem gegen Oxidation vergleichsweise unempfindlichen Metall gebildet, das ein Bestandteil der Lotschicht ist. Dies hat den Vorteil, dass die Oxidationsschutzschicht beim Aufschmelzen während des Lötvorgangs eine Legierung mit der Lotschicht ausbildet. Beispielsweise kann die Lotschicht AuSn enthalten und die Oxidationsschutzschicht eine Au-Schicht sein.

Die Dicke der Oxidationsschutzschicht beträgt vorteilhaft zwischen einschließlich 50 nm und einschließlich 200 nm. Die Dicke der Oxidationsschutzschicht ist in diesem Fall ausreichend gering, dass sich die Stöchiometrie der Lotschicht beim Aufschmelzen und Verschmelzen mit der Oxidationsschutzschicht und der Barriereschicht nur vergleichsweise geringfügig verändert.

Bei einer weiteren bevorzugten Ausführungsform der Erfindung ist zwischen dem Halbleiterchip und der Lotschicht eine Benetzungsschicht enthalten. Zwischen der Benetzungsschicht und der Lotschicht ist vorteilhaft eine zweite Barriereschicht angeordnet. Durch die Benetzungsschicht wird die Benetzung einer Oberfläche, auf die die Lotschicht aufgebracht wird, verbessert. Dies ist insbesondere dann vorteilhaft, wenn die Lotschicht auf eine Kontaktmetallisierung des Halbleiterchips aufgebracht ist, die von der Lotschicht nur schwer benetzbar ist. Die Benetzungsschicht ist insbesondere auch dann vorteilhaft, wenn zwischen einer Kontaktmetallisierung des Halbleiterchips und der Lotschicht eine Sperrschicht angeordnet ist, die von der Lotschicht nur schwer benetzbar ist. Eine derartige Sperrschicht ist beispielsweise aus TiWN gebildet und verhindert die Diffusion von Lotbestandteilen in die Kontaktmetallisierung. Die Benetzungsschicht enthält vorteilhaft Pt, Ni, Pd, Au, Ag, Cu oder Sn.

Die zweite Barriereschicht verhindert vorteilhaft eine Reaktion zwischen der Benetzungsschicht und der Lotschicht beziehungsweise Bestandteilen der Lotschicht. Beispielsweise wird ein Abreichern eines Bestandsteils der Lotschicht, zum Beispiel Sn, an der Benetzungsschicht, die zum Beispiel aus Platin besteht, vermindert.

Die zweite Barriereschicht enthält vorzugsweise zumindest eines der Materialen Ti, V, Cr, Nb, Zr, Hf, Ta, Mo oder W. Die Dicke der zweiten Barriereschicht beträgt vorzugsweise zwischen einschließlich 5 nm und einschließlich 100 nm, besonders bevorzugt zwischen einschließlich 10 nm und einschließlich 50 nm.

Der Halbleiterchip ist vorzugsweise ein optoelektronischer Halbleiterchip, insbesondere ein strahlungsemittierender optoelektronischer Halbleiterchip. Der Halbleiterchip enthält vorzugsweise ein III-V-Verbindungshalbleitermaterial, insbesondere InₓAl_{y}Ga_{1-x-y}N, InₓAl_{y}Ga_{1-x-y}P oder InₓAl_{y}Ga_{1-x-y}As, jeweils mit 0≤x≤1, 0≤y≤1 und x+y≤1. Dabei muss das III-V-Verbindungshalbleitermaterial nicht zwingend eine mathematisch exakte Zusammensetzung nach einer der obigen Formeln aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhalten obige Formeln jedoch nur die wesentlichen Bestandteile des Kristallgitters, auch wenn diese teilweise durch geringe Mengen weiterer Stoffe ersetzt sein können.

Bei einer bevorzugten Ausführungsform ist der Halbleiterchip ein Dünnfilm-Leuchtdiodenchip. Bei einem Dünnfilm-Leuchtdiodenchip wird eine funktionelle Halbleiterschichtenfolge zunächst epitaktisch auf einem Aufwachssubstrat aufgewachsen und nachfolgend an einer dem Aufwachssubstrat gegenüberliegenden Oberfläche der Halbleiterschichtenfolge auf einen neuen Träger gelötet. Die Lötschichtenfolge ist bei dieser Ausführungsform der Erfindung zum Löten des Dünnfilm-Leuchtdiodenchips auf den neuen Träger vorgesehen. Das Aufwachssubstrat kann nachfolgend abgetrennt und vorteilhaft wiederverwendet werden kann.

Ein Dünnfilm-Leuchtdioden-Chip zeichnet sich insbesondere durch folgende charakteristische Merkmale aus:
- an einer zu einem Träger hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20pm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Bei einem erfindungsgemäßen Verfahren zur Ausbildung einer Lötverbindung zwischen einem Träger und einem Halbleiterchip, wobei entweder auf den Halbleiterchip oder den Träger eine zur Herstellung einer Lötverbindung vorgesehenen Schichtenfolge aufgebracht ist, die eine Lotschicht und eine in einer Wachstumsrichtung der Schichtenfolge der Lotschicht nachfolgende Oxidationsschutzschicht umfasst, wobei zwischen der Lotschicht und der Oxidationsschutzschicht eine Barriereschicht enthalten ist, wobei die Barriereschicht eine Diffusion eines Materials, das Bestandteil der Lotschicht ist, durch die Oxidationsschutzschicht bei einer Temperatur, die kleiner als die vorgesehene Löttemperatur ist, vermindert, schmilzt die Lotschicht beim Lötvorgang auf, wobei die sich die Barriereschicht und die Oxidationsschutzschicht mit der Lotschicht vermischen. Vor dem Lötvorgang weist die Barriereschicht eine Dicke auf, die höchstens 50 nm beträgt.

Die Barriereschicht und die Oxidationsschutzschicht werden also beim Lötvorgang von der Lotschicht aufgezehrt.

Das Aufschmelzen der Lotschicht erfolgt vorzugsweise durch das Aufsetzen des mit der Schichtenfolge versehenen Halbleiterchips auf eine auf die vorgesehene Löttemperatur aufgeheizte Trägeroberfläche.

Die Barriereschicht vermindert vorteilhaft eine Diffusion eines Materials, das Bestandteil der Lotschicht ist, durch die Oxidationsschutzschicht bei einer Temperatur, die kleiner als die vorgesehene Löttemperatur ist. Insbesondere wird die Diffusion eines Bestandteils der Lotschicht, zum Beispiel Zinn, bei der Lagerung des Halbleiterchips vor der Lötmontage, beispielsweise bei Zimmertemperatur, vermindert. Ferner wird die Diffusion auch verzögert, wenn der Halbleiterchip vor dem Lötvorgang über einer aufgeheizten Lötmontagefläche positioniert wird.

Die zuvor im Zusammenhang mit dem erfindungsgemäßen Halbleiterchip beschriebenen vorteilhaften Ausgestaltungen gelten auch für das erfindungsgemäße Verfahren.

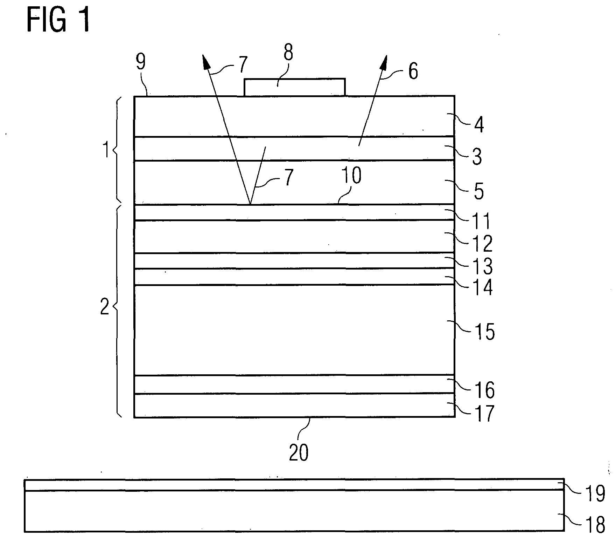

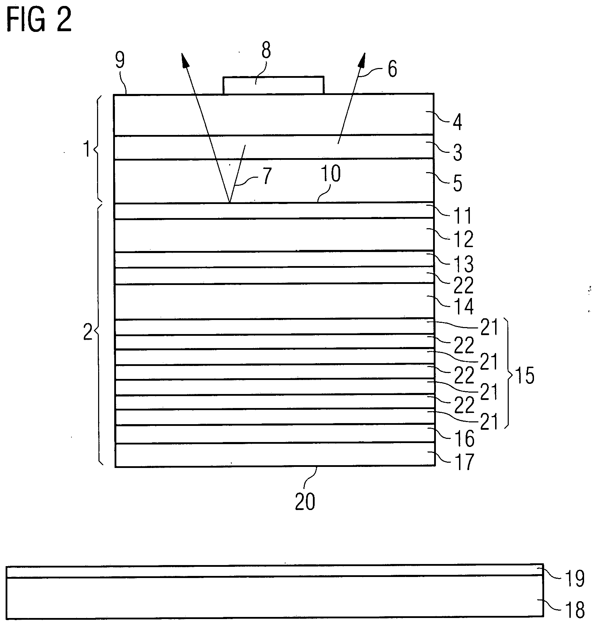

Die Erfindung wird im folgenden anhand von zwei Ausführungsbeispielen in Zusammenhang mit den Figuren 1 und 2 näher erläutert.

### Es zeigen:

- Figur 1: eine schematische Darstellung eines Querschnitts durch ein erstes Ausführungsbeispiel eines Halbleiterchips gemäß der Erfindung und
- Figur 2: eine schematische Darstellung eines Querschnitts durch ein zweites Ausführungsbeispiel eines Halbleiterchips gemäß der Erfindung.

Gleiche oder gleichwirkende Elemente sind in den Figuren mit den gleichen Bezugszeichen versehen.

Bei dem in Figur 1 dargestellten ersten Ausführungsbeispiel der Erfindung ist eine zur Herstellung einer Lötverbindung vorgesehene Schichtenfolge 2 auf einen Halbleiterchip 1 aufgebracht. Der Halbleiterchip 1 ist vorzugsweise ein optoelektronischer Halbleiterchip, der insbesondere eine aktive Schicht 3, die zur Erzeugung von Strahlung 6, 7 vorgesehen ist, und weitere Halbleiterschichten, beispielsweise einen Bereich n-dotierter Halbleiterschichten 4 und einen Bereich p-dotierter Halbleiterschichten 5, enthält. Der Halbleiterchip 1 weist beispielsweise eine Kantenlänge etwa 1 mm oder weniger auf. Vorzugsweise ist er weniger als 400 µm, zum Beispiel etwa 190 µm dick.

Der Halbleiterchip 1 ist beispielsweise mittels eines ersten Anschlusskontakts 8, der auf die zur Strahlungsauskopplung vorgesehene vorderseitige Hauptfläche 9 des Halbleiterchips 1 aufgebracht ist, und einem zweiten elektrischen Anschlusskontakt, bei dem es sich zum Beispiel um eine auf eine rückseitige Hauptfläche 10 des Halbleiterchips 1 aufgebrachte Kontaktmetallisierung 11 handelt, elektrisch kontaktiert.

Die Schichtenfolge 2 umfasst insbesondere eine Lotschicht 15. Die Lotschicht 15 ist dazu vorgesehen, den Halbleiterchip 1 auf einem Träger 18 zu befestigen. Vorteilhaft stellt die Lotschicht 15 auch eine elektrisch leitende Verbindung zwischen der Kontaktmetallisierung 11 und einer elektrischen Anschlussstelle auf dem Träger 18, beispielsweise einer auf den Träger 18 aufgebrachten Leiterbahn 19, her.

Die Kontaktmetallisierung 11 ist vorzugsweise aus einem Metall oder einer Metalllegierung gebildet, beispielsweise aus Aluminium, Silber, Gold oder einer Goldgermaniumlegierung. Besonders bevorzugt bildet die Kontaktmetallisierung 11 einen ohmschen Kontakt mit der angrenzenden Halbleiterschicht 5 aus.

Bei einer bevorzugten Ausführungsform der Erfindung fungiert die Kontaktmetallisierung 11 als Reflektor für die aus der aktiven Schicht 3 in Richtung der Kontaktmetallisierung 11 emittierte Strahlung 7. Die Strahlung 7 wird dabei vorteilhaft an der an die Kontaktmetallisierung 11 angrenzenden rückseitigen Hauptfläche 10 des Halbleiterchips 1 in Richtung zur vorderseitigen Hauptfläche 9 reflektiert, an der sie aus dem Halbleiterchip 1 auskoppeln kann. Auf diese Weise wird eine Absorption der von der aktiven Schicht 3 emittierten Strahlung in der Schichtenfolge 2 vermindert und somit die Effizienz der Lichterzeugung erhöht. Um einen hohe Reflektivität der Kontaktmetallisierung 11 zu erzielen, weist das Material der Kontaktmetallisierung 11 vorzugsweise bei der Wellenlänge der emittierten Strahlung 6, 7 einen vergleichsweise großen Brechungsindexunterschied zur angrenzenden Halbleiterschicht 5 auf. Besonders geeignete Materialien für die Kontaktmetallisierung 11 sind beispielsweise Silber oder Aluminium.

Zwischen der Kontaktmetallisierung 11 und der Lotschicht 15 ist vorteilhaft eine Sperrschicht 12 enthalten. Die Sperrschicht 12 hat die Funktion, eine Diffusion von Bestandteilen der Lotschicht 15 in die Kontaktmetallisierung 11 zu verhindern. Beispielsweise handelt es sich bei der Sperrschicht um eine TiWN-Schicht, die vorteilhaft eine Dicke zwischen einschließlich 300 nm und einschließlich 500 nm aufweist.

Zwischen der Sperrschicht 12 und der Lotschicht 15 ist bei einer bevorzugten Ausführungsform der Erfindung eine Benetzungsschicht 13 enthalten. Dies ist insbesondere dann vorteilhaft, wenn das Material der Sperrschicht 12 von dem Material der Lotschicht 15 nicht gut benetzbar ist. Die Benetzungsschicht 10 ist vorzugsweise eine Platinschicht.

Die Lotschicht 15 enthält vorzugsweise zumindest eines der Materialien Zinn, Indium, Gallium oder Bismut. Die Dicke der Lotschicht beträgt vorteilhaft 3 µm oder weniger. Beispielsweise ist die Lotschicht 15 eine 2 µm dicke Sn-Schicht. Eine vergleichsweise geringe Dicke der Lotschicht hat insbesondere den Vorteil, dass die Gefahr, dass Bestandteile der Lotschicht, zum Beispiel Sn-Atome, 15 beim Lötvorgang an die Seitenflanken des Halbleiterchips 1 gelangen und dort einen Kurzschluss der Halbleiterschichten 3, 4, 5 verursachen, vermindert ist.

Zum Schutz der Lotschicht 15 vor Oxidation enthält die Schichtenfolge 2 auf einer vom Halbleiterchip 1 abgewandten Seite der Lotschicht 15 eine Oxidationsschutzschicht 17. Die Oxidationsschutzschicht 17 ist vorzugsweise aus einem gegen Oxidation vergleichsweise unempfindlichen Metall, vorzugsweise Gold, gebildet. Die Dicke der Oxidationsschutzschicht 17 beträgt vorteilhaft zwischen einschließlich 50 nm und einschließlich 200 nm. Beispielsweise ist die Oxidationsschutzschicht 17 eine 100 nm dicke Au-Schicht.

Zwischen der Lotschicht 15 und der Oxidationsschutzschicht 17 ist eine Barriereschicht 16 angeordnet. Die Barriereschicht 16 enthält bevorzugt zumindest eines der Materialien Titan, Vanadium, Chrom oder Niob. Die Dicke der Barriereschicht 16 beträgt vorteilhaft zwischen einschließlich 5 nm und einschließlich 100 nm, besonders bevorzugt zwischen einschließlich 10 nm und einschließlich 50 nm. Bei einer derartige Dicke ist die Barriereschicht einerseits dick genug, um eine Diffusion eines Lotbestandteils in die Oxidationsschutzschicht 17 effektiv zu vermindern und andererseits dünn genug, dass die Stöchiometrie der Lotschicht 15 beim Aufschmelzen und Verschmelzen mit der Barriereschicht 10 und der Oxidationsschutzschicht 17 nur geringfügig verändert wird.

Durch die Barriereschicht 16, zum Beispiel eine 10 nm dicke Titanschicht, wird vorteilhaft eine Diffusion von Bestandteilen der Lotschicht, beispielsweise Zinn-Atomen, in die Oxidationsschutzschicht 17 verhindert. Andernfalls würde die Gefahr bestehen, dass Bestandteile der Lotschicht 15 bis an die Oberfläche 20 der Oxidationsschutzschicht 17 diffundieren und dort zu einer Oxidbildung führen. Dies könnte dazu führen, dass bei einem Lötvorgang offene, sogenannte kalte Lötstellen oder an nur wenigen Punkten verbundene Lötverbindungen entstehen würden.

Die Barriereschicht 16 ist insbesondere dann vorteilhaft, wenn zwischen dem Aufbringen der Lotschicht und der Lötmontage des Halbleiterchips auf einen Träger 18 eine derart lange Lagerung des Halbleiterchips 1 erfolgt, dass ohne die Barriereschicht 16 bereits bei Zimmertemperatur eine Diffusion eines Lotbestandteils an die Oberfläche 20 der Oxidationsschutzschicht 17 erfolgen könnte.

Weiterhin ist die Barriereschicht 16 besonders dann vorteilhaft, wenn der Halbleiterchip zwischen dem Aufbringen der Lotschicht 15 und der Lötmontage weiteren Prozessschritten ausgesetzt ist, bei denen erhöhte Temperaturen auftreten, die eine Diffusion von Lotbestandteilen begünstigen würden.

Zwischen der Benetzungsschicht 13 und der Lotschicht 15 ist vorteilhaft eine zweite Barriereschicht 14 enthalten. Die zweite Barriereschicht 14 verhindert vorteilhaft eine Reaktion zwischen einem Bestandteil der Lotschicht 15, beispielsweise Zinn, und dem Material der Benetzungsschicht 13, beispielsweise Platin.

Wie die Barriereschicht 16, die zwischen der Lotschicht 15 und der Oxidationsschutzschicht 17 angeordnet ist, enthält die zweite Barriereschicht 14 zumindest eines der Materialien Titan, Vanadium, Chrom oder Niob. Die Dicke der zweiten Barriereschicht beträgt bevorzugt zwischen einschließlich 5 nm und einschließlich 100 nm, besonders bevorzugt zwischen einschließlich 10 nm und einschließlich 50 nm. Die Barriereschicht 16 und die zweite Barriereschicht 14 können zum Beispiel aus dem gleichen Material gefertigt sein, wodurch der Herstellungsaufwand vergleichsweise gering ist. Beispielsweise ist die Barriereschicht 16 eine 10 nm dicke Titanschicht und die zweite Barriereschicht 14 eine 50 nm dicke Titanschicht.

Der für den Halbleiterchip 1 vorgesehene Träger 18 kann insbesondere eine Leiterplatte oder ein Leiterrahmen sein. Weiterhin kann Träger 18 aus einer Keramik gebildet sein und beispielsweise als Träger für mehrere Halbleiterchips vorgesehen sein. Ferner kann der Träger 18 auch ein LED-Gehäuse sein.

Zur Herstellung einer Lötverbindung zwischen dem Träger 18 und dem Halbleiterchip 1 wird zum Beispiel der Träger 18 auf die für den Lötvorgang vorgesehene Temperatur geheizt und der Halbleiterchip 1, auf den die zur Herstellung der Lötverbindung vorgesehene Schichtenfolge 2 aufgebracht ist, an der Oberfläche 20 der Oxidationsschutzschicht 17 auf den Träger 18 beziehungsweise auf eine auf den Träger aufgebrachte Metallisierung 19, beispielsweise eine Leiterbahn, aufgesetzt und vorzugsweise angepresst. Die Barriereschichten 14, 16, die Lotschicht 15 und die Oxidationsschutzschicht 17 schmelzen beim Lötvorgang auf, wobei die jeweiligen Materialien der Barriereschicht 16 und der zweiten Barriereschicht 14 entweder mit dem Material der Lotschicht 15 eine intermetallische Verbindung ausbilden oder sich in anderer Form im Bereich der Lötverbindung verteilen. Vor dem Aufschmelzen der Schichten, beispielsweise bei einer Lagerung des Halbleiterchips 1 vor der Lötmontage oder bei der Positionierung des Halbleiterchips 1 über dem bereits aufgeheizten Träger 18, wird die Diffusion eines Bestandteils der Lotschicht 15, insbesondere Zinn, an die Oberfläche der Oxidationsschutzschicht 17 durch die Barriereschicht 16 vorteilhaft verhindert.

Bei dem in der Figur 2 dargestellten zweiten Ausführungsbeispiel eines Halbleiterchips 1 gemäß der Erfindung ist die Lotschicht 15 keine Einzelschicht, sondern ein Schichtstapel aus einer Vielzahl von Zinnschichten 21 und Goldschichten 22. Die Zinnschichten 21 und die Goldschichten 22 verschmelzen beim Lötvorgang zu einer AuSn-Legierung. Zwischen die als Schichtstapel ausgebildete Lotschicht 15 und die Oxidationsschutzschicht 17 ist wie bei dem ersten Ausführungsbeispiel eine Barriereschicht 16 eingefügt. Beispielsweise kann es sich bei der Barriereschicht 16 um eine 20 nm dicke Vanadiumschicht handeln.

Wie bei dem ersten Ausführungsbeispiel ist auch bei dem zweiten Ausführungsbeispiel eine zweite Barriereschicht 14, beispielsweise eine 50 nm dicke Titanschicht, zwischen der Benetzungsschicht 13 und der Lotschicht 15 enthalten. Die zweite Barriereschicht 14 ist im Gegensatz zum ersten Ausführungsbeispiel aber nicht unmittelbar auf die Benetzungsschicht 13 aufgebracht. Vielmehr ist auf die von der Sperrschicht 12 abgewandte Seite der Benetzungsschicht 13 zunächst eine Goldschicht 22, nachfolgend die zweite Barriereschicht 14 und nachfolgend eine erste Zinnschicht 21 des die Lotschicht 15 ausbildenden Schichtstapels aufgebracht. Die zweite Barriereschicht 14 grenzt somit unmittelbar an die Zinnschicht 21 an. Dies ist vorteilhaft, da eine Reaktion zwischen dem Material Zinn in dem Schichtstapel der Lotschicht 15 und dem Material Platin in der Benetzungsschicht 13 unterbunden werden soll. Ansonsten entspricht das zweite Ausführungsbeispiel im wesentlichen dem ersten Ausführungsbeispiel.

Die Schichtenfolge 2 muss nicht, wie in den beiden Ausführungsbeispielen dargestellt, ganzflächig auf den Halbleiterchip 1 aufgebracht sein. Vielmehr kann die Schichtenfolge 2 auch beliebig strukturiert sein, beispielsweise mittels Photolithographie oder Abhebetechnik. Insbesondere können sowohl ein n-Kontakt als auch ein p-Kontakt auf der dem Träger 18 zugewandten Seite des Halbleiterchips 1 angeordnet sein und beispielsweise beide mit einer zuvor beschriebenen Schichtenfolge 2 durch eine Lötverbindung mit jeweils einer Leiterbahn auf dem Träger 18 verbunden sein.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Halbleiterchip (1) auf den eine zur Herstellung einer Lötverbindung vorgesehenen Schichtenfolge (2) aufgebracht ist, wobei die Schichtenfolge (2) eine Lotschicht (15) und eine vom Halbleiterchip (1) aus gesehen der Lotschicht (15) nachfolgende Oxidationsschutzschicht (17) umfasst, wobei zwischen der Lotschicht (15) und der Oxidationsschutzschicht (17) eine Barriereschicht (16) enthalten ist, wobei die Barriereschicht (16) eine Diffusion eines Materials, das Bestandteil der Lotschicht (15) ist, durch die Oxidationsschutzschicht (17) vermindert,
**dadurch gekennzeichnet, dass**
- die Barriereschicht (16) eine Dicke aufweist und die Dicke höchstens 50 nm beträgt.

2. Halbleiterchip nach Anspruch 1, wobei
- die Oxidationsschutzschicht (17) Au, Pt, Pd, Ir, Ag oder Rh enthält.

3. Halbleiterchip nach Anspruch 1, **dadurch gekennzeichnet, dass**
die Barriereschicht (16) Ti, V, Cr, Nb, Zr, Hf, Ta, Mo oder W enthält.

4. Halbleiterchip nach einem der vorhergehenden Ansprüche, **dadurch gekennzeichnet, dass**
die Barriereschicht (16) eine Dicke von zumindest 5 nm aufweist.

5. Halbleiterchip nach einem der vorhergehenden Ansprüche,
**dadurch gekennzeichnet, dass**
die Lotschicht (15) Sn, In, Ga, Bi, Pb, Sb, Zn, Cd, Hg, Tl, AuSn, AuIn, AuBi, AgSn oder PbSn enthält.

6. Halbleiterchip nach einem der vorhergehenden Ansprüche,
**dadurch gekennzeichnet, dass**
die Dicke der Lotschicht (15) 3 µm oder weniger beträgt.

7. Halbleiterchip nach einem der vorhergehenden Ansprüche,
**dadurch gekennzeichnet, dass**
die Oxidationsschutzschicht (17) zwischen einschließlich 50 nm und einschließlich 200 nm dick ist.

8. Halbleiterchip nach einem der vorhergehenden Ansprüche,
**dadurch gekennzeichnet, dass**
zwischen dem Halbleiterchip (1) und der Lotschicht (15) eine Benetzungsschicht (13) enthalten ist, wobei zwischen der Benetzungsschicht (13) und der Lotschicht (15) eine zweite Barriereschicht (14) angeordnet ist.

9. Halbleiterchip nach Anspruch 8,
**dadurch gekennzeichnet, dass**
die zweite Barriereschicht (14) Ti, V, Cr, Nb, Zr, Hf, Ta, Mo oder W enthält.

10. Halbleiterchip nach Anspruch 8 oder 9,
**dadurch gekennzeichnet, dass**
die zweite Barriereschicht (14) eine Dicke zwischen einschließlich 5 nm und einschließlich 100 nm, bevorzugt zwischen einschließlich 10 nm und einschließlich 50 nm, aufweist.

11. Halbleiterchip nach einem der Ansprüche 8 bis 10,
**dadurch gekennzeichnet, dass**
die Benetzungsschicht (13) Pt, Ni, Pd, Au, Ag, Cu oder Sn enthält.

12. Halbleiterchip nach einem der vorhergehenden Ansprüche,
**dadurch gekennzeichnet, dass** die Lotschicht (15) Sn, In, Ga, Bi, Pb, Sb, Zn, Cd, Hg, Tl, AuSn, AuIn, AuBi, AgSn oder PbSn enthält,
die Barriereschicht (16) Ti, V, Cr, Nb, Zr, Hf, Ta, Mo oder W enthält und,
die Oxidationsschutzschicht (17) Au, Pt, Pd, Ir, Ag oder Rh enthält.

13. Halbleiterchip nach Anspruch 12,
**dadurch gekennzeichnet, dass**
der Halbleiterchip (1) ein Dünnfilm-Leuchtdiodenchip ist.

14. Verfahren zur Ausbildung einer Lötverbindung zwischen einem Träger (18) und einem Halbleiterchip (1), wobei auf den Träger (18) oder den Halbleiterchip (1) eine zur Herstellung der Lötverbindung vorgesehenen Schichtenfolge (2) aufgebracht ist, wobei
die Schichtenfolge (2) eine Lotschicht (15) und eine in einer Wachstumsrichtung der Schichtenfolge (2) der Lotschicht (15) nachfolgende Oxidationsschutzschicht (17) umfasst, wobei zwischen der Lotschicht (15) und der Oxidationsschutzschicht (17) eine Barriereschicht (16) enthalten ist, wobei die Barriereschicht (16) eine Diffusion eines Materials, das Bestandteil der Lotschicht (15) ist, durch die Oxidationsschutzschicht (17) bei einer Temperatur, die kleiner als die vorgesehene Löttemperatur ist, vermindert, und wobei beim Lötvorgang die Lotschicht (15) aufschmilzt und sich die Barriereschicht (16) und die Oxidationsschutzschicht (17) mit der Lotschicht (15) vermischen, **dadurch gekennzeichnet dass**
vor dem Lötvorgang
- die Barriereschicht (16) eine Dicke aufweist und die Dicke höchstens 50 nm beträgt.

15. Verfahren nach Anspruch 14, wobei
- die Oxidationsschutzschicht (17) Au, Pt, Pd, Ir, Ag oder Rh enthält.

16. Verfahren nach Anspruch 14 oder 15,
**dadurch gekennzeichnet, dass**
die Schichtenfolge (2) auf dem Halbleiterchip (1) angeordnet ist und das Aufschmelzen durch das Aufsetzen des Halbleiterchips (1) auf eine aufgeheizte Oberfläche des Trägers (18) erfolgt.

17. Verfahren nach einem der Ansprüche 14 bis 16,
**dadurch gekennzeichnet, dass**
die Barriereschicht (16) Ti, V, Cr, Nb, Zr, Hf, Ta, Mo oder W enthält.

18. Verfahren nach einem der Ansprüche 14 bis 17,
**dadurch gekennzeichnet, dass**
die Barriereschicht (16) eine Dicke von zumindest5 nm aufweist.

19. Verfahren nach einem der Ansprüche 14 bis 18,
**dadurch gekennzeichnet, dass**
die Lotschicht (15) Sn, In, Ga, Bi, Pb, Sb, Zn, Cd, Hg, Tl, AuSn, AuIn, AuBi, AgSn oder PbSn enthält.

20. Verfahren nach einem der Ansprüche 14 bis 19,
**dadurch gekennzeichnet, dass**
die Dicke der Lotschicht (15) 3 µm oder weniger beträgt.

21. Verfahren nach einem der Ansprüche 14 bis 20,
**dadurch gekennzeichnet, dass**
die Oxidationsschutzschicht (17) zwischen einschließlich 50 nm und einschließlich 200 nm dick ist.

22. Verfahren nach einem der Ansprüche 14 bis 21,
**dadurch gekennzeichnet, dass**
zwischen dem Halbleiterchip (1) oder dem Trägerkörper (18) und der Lotschicht (15) eine Benetzungsschicht (13) enthalten ist, wobei zwischen der Benetzungsschicht (13) und der Lotschicht (15) eine zweite Barriereschicht (14) angeordnet ist.

23. Verfahren nach Anspruch 22,
**dadurch gekennzeichnet, dass**
die zweite Barriereschicht (14) Ti, V, Cr, Nb, Zr, Hf, Ta, Mo oder W enthält.

24. Verfahren nach einem der Ansprüche 22 oder 23,
**dadurch gekennzeichnet, dass**
die zweite Barriereschicht (14) eine Dicke zwischen einschließlich 5 nm und einschließlich 100 nm, bevorzugt zwischen einschließlich 10 nm und einschließlich 50 nm, aufweist.

25. Verfahren nach einem der Ansprüche 22 bis 24,
**dadurch gekennzeichnet, dass**
die Benetzungsschicht (13) Pt, Ni, Pd, Au, Ag, Cu oder Sn enthält.

26. Verfahren nach einem der Ansprüche 22 bis 25,
**dadurch gekennzeichnet, dass**
die Lotschicht (15) Sn, In, Ga, Bi, Pb, Sb, Zn, Cd, Hg, Tl, AuSn, AuIn, AuBi, AgSn oder PbSn enthält,
die Barriereschicht (16) Ti, V, Cr, Nb, Zr, Hf, Ta, Mo oder W enthält und,
die Oxidationsschutzschicht (17) Au, Pt, Pd, Ir, Ag oder Rh enthält.

27. Verfahren nach Anspruch 26,
**dadurch gekennzeichnet, dass**
der Halbleiterchip (1) ein Dünnfilm-Leuchtdiodenchip ist.

## Claims

1. A semiconductor chip (1) having a layer sequence (2), which is intended to produce a soldered connection and comprises a solder layer (15) and an oxidation prevention layer (17), which follows the solder layer (15) as seen from the semiconductor chip (1), wherein
a barrier layer (16) is included between the solder layer (15) and the oxidation prevention layer (17), wherein the barrier layer (16) reduces diffusion of a material that is a constituent of the solder layer (15) through the oxidation prevention layer (17),
**characterised in that**
- the barrier layer (16) has a thickness and the thickness is at most 50 nm.

2. The semiconductor chip according to claim 1, wherein
- the oxidation prevention layer (17) contains Au, Pt, Pd, Ir, Ag or Rh.

3. The semiconductor chip according to claim 1,
**characterised in that**
the barrier layer (16) contains Ti, V, Cr, Nb, Zr, Hf, Ta, Mo or W.

4. The semiconductor chip according to one of the preceding claims,
**characterised in that**
the barrier layer (16) has a thickness of at least 5 nm.

5. The semiconductor chip according to one of the preceding claims,
**characterised in that**
the solder layer (15) contains Sn, In, Ga, Bi, Pb, Sb, Zn, Cd, Hg, Tl, AuSn, AuIn, AuBi, AgSn or PbSn.

6. The semiconductor chip according to one of the preceding claims,
**characterised in that**
the thickness of the solder layer (15) is 3 µm or less.

7. The semiconductor chip according to one of the preceding claims,
**characterised in that**
the oxidation prevention layer (17) is between 50 nm and 200 nm inclusive thick.

8. The semiconductor chip according to one of the preceding claims,
**characterised in that**
a wetting layer (13) is included between the semiconductor chip (1) and the solder layer (15), a second barrier layer (14) being arranged between the wetting layer (13) and the solder layer (15) .

9. The semiconductor chip according to claim 8,
**characterised in that**
the second barrier layer (14) contains Ti, V, Cr, Nb, Zr, Hf, Ta, Mo or W.

10. The semiconductor chip according to claim 8 or 9, **characterised in that**
the second barrier layer (14) has a thickness between 5 nm and 100 nm inclusive, preferably between 10 nm and 50 nm inclusive.

11. The semiconductor chip according to one of claims 8 to 10, **characterised in that**
the wetting layer (13) contains Pt, Ni, Pd, Au, Ag, Cu or Sn.

12. The semiconductor chip according to one of the preceding claims,
**characterized in that** the solder layer (15) contains Sn, In, Ga, Bi, Pb, Sb, Zn, Cd, Hg, Tl, AuSn, AuIn, AuBi, AgSn or PbSn,
the barrier layer (16) contains Ti, V, Cr, Nb, Zr, Hf, Ta, Mo or W and,
the oxidation prevention layer (17) contains Au, Pt, Pd, Ir, Ag or Rh.

13. The semiconductor chip according to claim 12,
**characterised in that**
the semiconductor chip (1) is a thin-film light-emitting diode chip.

14. A process for forming a solder connection between a carrier (18) and a semiconductor chip (1), wherein a layer sequence (2) provided for producing the solder connection is applied to the carrier (18) or the semiconductor chip (1), wherein
the layer sequence (2) comprises a solder layer (15) and an oxidation prevention layer (17) following the solder layer (15) in a growth direction of the layer sequence (2), wherein a barrier layer (16) is included between the solder layer (15) and the oxidation prevention layer (17), wherein the barrier layer (16) reduces diffusion of a material, that is a constituent of the solder layer (15), through the oxidation prevention layer (17) at a temperature which is lower than the intended soldering temperature, and wherein during the soldering process the solder layer (15) melts and the barrier layer (16) and the oxidation prevention layer (17) mix with the solder layer (15), **characterised in that**
before the soldering process
- the barrier layer (16) has a thickness and the thickness is at most 50 nm.

15. The process according to claim 14, wherein
- the oxidation prevention layer (17) contains Au, Pt, Pd, Ir, Ag or Rh.

16. The process according to claim 14 or 15,
**characterised in that**
the layer sequence (2) is arranged on the semiconductor chip (1) and the melting is effected by placing the semiconductor chip (1) on a heated surface of the carrier (18).

17. The process according to one of claims 14 to 16, **characterised in that**
the barrier layer (16) contains Ti, V, Cr, Nb, Zr, Hf, Ta, Mo or W.

18. The process according to one of claims 14 to 17, **characterised in that**
the barrier layer (16) has a thickness of at least 5 nm.

19. The process according to one of claims 14 to 18, **characterised in that**
the solder layer (15) contains Sn, In, Ga, Bi, Pb, Sb, Zn, Cd, Hg, Tl, AuSn, AuIn, AuBi, AgSn or PbSn.

20. The process according to one of claims 14 to 19, **characterised in that**
the thickness of the solder layer (15) is 3 µm or less.

21. The process according to one of claims 14 to 20, **characterised in that**
the oxidation prevention layer (17) is between 50 nm and 200 nm inclusive thick.

22. The process according to one of claims 14 to 21, **characterised in that**
a wetting layer (13) is included between the semiconductor chip (1) or the carrier body (18) and the solder layer (15), a second barrier layer (14) being arranged between the wetting layer (13) and the solder layer (15).

23. The process according to claim 22,
**characterised in that**
the second barrier layer (14) contains Ti, V, Cr, Nb, Zr, Hf, Ta, Mo or W.

24. The process according to one of claims 22 or 23, **characterised in that**
the second barrier layer (14) has a thickness between 5 nm and 100 nm inclusive, preferably between 10 nm and 50 nm inclusive.

25. The process according to one of claims 22 to 24, **characterised in that**
the wetting layer (13) contains Pt, Ni, Pd, Au, Ag, Cu or Sn.

26. The process according to one of claims 22 to 25, **characterised in that**
the solder layer (15) contains Sn, In, Ga, Bi, Pb, Sb, Zn, Cd, Hg, Tl, AuSn, AuIn, AuBi, AgSn or PbSn,
the barrier layer (16) contains Ti, V, Cr, Nb, Zr, Hf, Ta, Mo or W and,
the oxidation prevention layer (17) contains Au, Pt, Pd, Ir, Ag or Rh.

27. The process according to claim 26,
**characterised in that**
the semiconductor chip (1) is a thin-film light-emitting diode chip.

## Revendications

1. Puce électronique à semiconducteur (1) sur laquelle est appliquée une succession de couches (2) prévue en vue de la fabrication d'une connexion brasée, sachant que la succession de couches (2) comporte une couche de brasage (15) et, vue de la puce électronique (1), une couche de protection contre l'oxydation (17) suivant la couche de brasage (15), sachant que,
entre la couche de brasage (15) et la couche de protection contre l'oxydation (17) est contenue une couche barrière (16), sachant que la couche barrière (16) réduit une diffusion d'une matière qui est composante de la couche de brasage (15) par la couche de protection contre l'oxydation (17),
**caractérisée en ce que**
- la couche barrière (16) présente une épaisseur et l'épaisseur fait un maximum de 50 nm.

2. Puce électronique à semiconducteur selon la revendication 1, sachant que
- la couche de protection contre l'oxydation (17) contient de l'Au, du Pt, du Pd, de l'Ir, de l'Ag ou du Rh.

3. Puce électronique à semiconducteur selon la revendication 1, **caractérisée en ce que**
la couche barrière (16) contient du Ti, du V, du Cr, du Nb, du Zr, du Hf, du Ta, du Mo ou du W.

4. Puce électronique à semiconducteur selon une quelconque des revendications précédentes,
**caractérisée en ce que**
la couche barrière (16) présente une épaisseur d'au moins 5 nm.

5. Puce électronique à semiconducteur selon une quelconque des revendications précédentes,
**caractérisée en ce que**
la couche de brasage (15) contient du Sn, de l'In, du Ga, du Bi, du Pb, du Sb, du Zn, du Cd, du Hg, du Tl, de l'AuSn, de l'AuIn, de l'AuBi, de l'AgSn ou du PbSn.

6. Puce électronique à semiconducteur selon une quelconque des revendications précédentes,
**caractérisée en ce que**
l'épaisseur de la couche de brasage (15) est de 3 µm ou moins.

7. Puce électronique à semiconducteur selon une quelconque des revendications précédentes,
**caractérisée en ce que**
la couche de protection contre l'oxydation (17) fait entre 50 nm inclus et 200 nm inclus d'épaisseur.

8. Puce électronique à semiconducteur selon une quelconque des revendications précédentes,
**caractérisée en ce que**
entre la puce électronique à semiconducteur (1) et la couche de brasage (15) est contenue une couche de mouillage (13), sachant qu'entre la couche de mouillage (13) et la couche de brasage (15) est disposée une seconde couche barrière (14).

9. Puce électronique à semiconducteur selon la revendication 8, **caractérisée en ce que**
la seconde couche barrière (14) contient du Ti, du V, du Cr, du Nb, du Zr, du Hf, du Ta, du Mo ou du W.

10. Puce électronique à semiconducteur selon les revendications 8 ou 9,
**caractérisée en ce que**
la seconde couche barrière (14) présente une épaisseur comprise entre 5 nm inclus et 100 nm inclus, de préférence entre 10 nm inclus et 50 nm inclus.

11. Puce électronique à semiconducteur selon une quelconque des revendications 8 à 10,
**caractérisée en ce que**
la couche de mouillage (13) contient du Pt, du Ni, du Pd, de l'Au, de l'Ag, du Cu ou du Sn.

12. Puce électronique à semiconducteur selon une quelconque des revendications précédentes,
**caractérisée en ce que**
la couche de brasage (15) contient du Sn, de l'In, du Ga, du Bi, du Pb, du Sb, du Zn, du Cd, du Hg, du Tl, de l'AuSn, de l'AuIn, de l'AuBi, de l'AgSn ou du PbSn,
la couche barrière (16) contient du Ti, du V, du Cr, du Nb, du Zr, du Hf, du Ta, du Mo ou du W et,
la couche de protection contre l'oxydation (17) contient de l'Au, du Pt, du Pd, de l'Ir, de l'Ag ou du Rh.

13. Puce électronique à semiconducteur selon la revendication 12, **caractérisée en ce que**
la puce électronique à semiconducteur (1) est une puce électronique de diode luminescente à film fin.

14. Procédé en vue de la constitution d'une connexion brasée entre un support (18) et une puce électronique à semiconducteur (1), sachant que sur le support (18) ou sur la puce électronique à semiconducteur (1) est appliquée une succession de couches (2) prévue pour la fabrication de la connexion brasée, sachant que
la succession de couches (2) comporte une couche de brasage (15) et une couche de protection contre l'oxydation (17) suivante dans une direction de croissance de la succession de couches (2) de la couche de brasage (15), sachant que entre la couche de brasage (15) et la couche de protection contre l'oxydation (17) est contenue une couche barrière (16), sachant que
la couche barrière (16) réduit une diffusion d'une matière qui est composante de la couche de brasage (15) par la couche de protection contre l'oxydation (17) à une température qui est inférieure à la température de brasage prévue, et sachant que
lors de l'opération de brasage, la couche de brasage (15) fond et que la couche barrière (16) et la couche de protection contre l'oxydation (17) se mélangent avec la couche de brasage (15),
**caractérisé en ce que**
avant l'opération de brasage,
- la couche barrière (16) présente une épaisseur et l'épaisseur fait un maximum de 50 nm.

15. Procédé selon la revendication 14, selon lequel
- la couche de protection contre l'oxydation (17) contient de l'Au, du Pt, du Pd, de l'Ir, de l'Ag ou du Rh.

16. Procédé selon les revendications 14 ou 15,
**caractérisé en ce que**
la succession de couches (2) est disposée sur la puce électronique à semiconducteur (1) et la fusion s'effectue par la mise en place de la puce électronique à semiconducteur (1) sur une surface chauffée du support (18).

17. Procédé selon une quelconque des revendications 14 à 16, **caractérisé en ce que**
la couche barrière (16) contient du Ti, du V, du Cr, du Nb, du Zr, du Hf, du Ta, du Mo ou du W.

18. Procédé selon une quelconque des revendications 14 à 17, **caractérisé en ce que**
la couche barrière (16) présente une épaisseur d'au moins 5 nm.

19. Procédé selon une quelconque des revendications 14 à 18, **caractérisé en ce que**
la couche de brasage (15) contient du Sn, de l'In, du Ga, du Bi, du Pb, du Sb, du Zn, du Cd, du Hg, du Tl, de l'AuSn, de l'AuIn, de l'AuBi, de l'AgSn ou du PbSn.

20. Procédé selon une quelconque des revendications 14 à 19, **caractérisé en ce que**
l'épaisseur de la couche de brasage (15) est de 3 µm ou moins.

21. Procédé selon une quelconque des revendications 14 à 20, **caractérisé en ce que**
la couche de protection contre l'oxydation (17) fait entre 50 nm inclus et 200 nm inclus d'épaisseur.

22. Procédé selon une quelconque des revendications 14 à 21, **caractérisé en ce que**
entre la puce électronique à semiconducteur (1) et la couche de brasage (15) est contenue une couche de mouillage (13), sachant qu'entre la couche de mouillage (13) et la couche de brasage (15) est disposée une seconde couche barrière (14).

23. Procédé selon la revendication 22,
**caractérisé en ce que**
la seconde couche barrière (14) contient du Ti, du V, du Cr, du Nb, du Zr, du Hf, du Ta, du Mo ou du W.

24. Procédé selon une quelconque des revendications 22 ou 23, **caractérisé en ce que**
la seconde couche barrière (14) présente une épaisseur comprise entre 5 nm inclus et 100 nm inclus, de préférence entre 10 nm inclus et 50 nm inclus.

25. Procédé selon une quelconque des revendications 22 à 24, **caractérisé en ce que**
la couche de mouillage (13) contient du Pt, du Ni, du Pd, de l'Au, de l'Ag, du Cu ou du Sn.

26. Procédé selon une quelconque des revendications 22 à 25, **caractérisé en ce que**
la couche de brasage (15) contient du Sn, de l'In, du Ga, du Bi, du Pb, du Sb, du Zn, du Cd, du Hg, du Tl, de l'AuSn, de l'AuIn, de l'AuBi, de l'AgSn ou du PbSn,
la couche barrière (16) contient du Ti, du V, du Cr, du Nb, du Zr, du Hf, du Ta, du Mo ou du W et,
la couche de protection contre l'oxydation (17) contient de l'Au, du Pt, du Pd, de l'Ir, de l'Ag ou du Rh.

27. Procédé selon la revendication 26,
**caractérisé en ce que**
la puce électronique à semiconducteur (1) est une puce électronique de diode luminescente à film fin.
